# EUROPÄISCHE PATENTSCHRIFT

(11) **EP 1 591 757 B1**
(45) Veröffentlichungstag und Bekanntmachung des Hinweises auf die Patenterteilung: **02.11.2006**
(21) Anmeldenummer: 04010091.9
(22) Anmeldetag: 28.04.2004
(51) Int. Cl.: G01D 5/14, G01D 5/26, G01D 5/32, H01H 35/02, H01H 35/14, G01P 15/08

(54) **Lagesensorvorrichtung**
Position sensor device
Capteur de position

(43) Veröffentlichungstag der Anmeldung: 02.11.2005
(73) Patentinhaber: Delphi Technologies, Inc., Troy, MI 48007 (US)
(72) Erfinder: Engelberth, Horst, 51674 Wiehl (DE)
(74) Vertreter: Manitz, Finsterwald & Partner GbR

(56) Entgegenhaltungen:
- DE-U- 29 820 652
- US-A- 5 535 639
- US-A- 5 631 557
- US-A1- 2003 210 442

## Beschreibung

Die vorliegende Erfindung betrifft eine Lagesensorvorrichtung zur Detektion der Lage eines auf einer vorgegebenen Bahn bewegbaren, durch einen Körper oder einen Abschnitt eines Körpers gegebenen Ziels.

Lagesensorvorrichtungen der oben genannten Art sind grundsätzlich bekannt (siehe z.B. DE-U-298 20 652). Sie dienen dazu, die Lage eines Ziels, das durch einen Körper oder auch nur einen Abschnitt eines Körpers gegeben sein kann, zu erfassen. Hierzu können berührungslos arbeitende Sensoren verwendet werden, die ein Eintreten des Ziels in ihren Erfassungsbereich detektieren, wodurch eine Lage in dem Erfassungsbereich erkannt wird. Um die Lage des Körpers nicht nur relativ zu dem Erfassungsbereich des Sensors, sondern auch in Bezug auf ein anderes Bezugssystem oder andere Gegenstände ermitteln zu können, ist es notwendig, diesen Sensor und damit dessen Erfassungsbereich in Bezug auf das Bezugssystem oder die anderen Gegenstände zu justieren. Die Genauigkeit der Lageermittlung wird in diesem Fall wesentlich von der Güte der Justierung bestimmt.

Eine Justierung durch Bewegung der gesamten Lagesensorvorrichtung relativ zu der Bahn des Ziels ist zwar theoretisch möglich, in der Praxis jedoch häufig nicht durchführbar.

Es ist vorstellbar, Lagesensorvorrichtungen der oben genannten Art zur Herstellung berührungslos arbeitender Schalter zu verwenden. Dabei kann die Bewegung bzw. Lageänderung eines Betätigungselements des Schalters durch die Lagesensorvorrichtung ermittelt werden. Der Schaltpunkt, d.h. die Stellung des Betätigungselements, bei dem bzw. der ein Schalten ausgelöst wird, wird durch die genaue Lage des Sensors relativ zu dem Betätigungselement bestimmt. Schwankt die Relativlage zwischen Sensor und Betätigungselement, so schwankt dementsprechend auch der Schaltpunkt, was unerwünscht ist.

Es ist dabei insbesondere denkbar, als Sensor für einen solchen Schalter bzw. eine Lagesensorvorrichtung Lichtschranken zu verwenden. Da solche Lichtschranken jedoch vergleichsweise großen Toleranzen in der Lage des Erfassungsbereichs relativ zu einem Gehäuse der Lichtschranken aufweisen, würden sich Schaltpunkte mit unerwünscht großen Toleranzen ergeben.

Der vorliegenden Erfindung liegt daher die Aufgabe zugrunde, eine Lagesensorvorrichtung der oben genannten Art zu schaffen, die eine Lageermittlung mit geringen Toleranzen erlaubt.

Die Aufgabe wird gelöst durch eine Lagesensorvorrichtung mit den Merkmalen des Anspruchs 1.

Die erfindungsgemäße Lagesensorvorrichtung zur Detektion der Lage eines auf einer vorgegebenen Bahn bewegbaren, durch einen Körper oder einen Abschnitt eines Körpers gegebenen Ziels umfasst einen flexiblen Schaltungsträger und wenigstens einen auf dem Schaltungsträger angeordneten, berührungslos arbeitenden Sensor, der auf eine Bewegung des Ziels in einem vorgegebenen Erfassungsbereich des Sensors und/oder aus diesem heraus oder auf die Anwesenheit des Ziels in dem vorgegebenen Erfassungsbereich anspricht und dessen Lage zur Justierung relativ zu der vorgegebenen Bahn und der wenigstens teilweisen Verformung des Schaltungsträgers veränderbar ist.

Die erfindungsgemäße Lagesensorvorrichtung umfasst zunächst den berührungslos arbeitenden Sensor, der das Ziel erfasst, wenn sich dieses in den Erfassungsbereich des Sensors hinein und/oder aus diesem heraus bewegt und/oder wenn sich dieses in dem Erfassungsbereich befindet. Um die Lage des Ziels ermitteln zu können, wird bei der Verwendung der erfindungsgemäßen Vorrichtung der Sensor so angeordnet, dass der Erfassungsbereich des Sensors die vorgegebene Bahn überschneidet.

Je nach Art des verwendeten Sensors kann dieser insbesondere nur die Anwesenheit des Ziels in dem Erfassungsbereich erfassen, wodurch auch die Bewegung des Ziels in den Erfassungsbereich oder aus diesem heraus erfassbar ist. Der Sensor kann jedoch auch so ausgebildet sein, dass er nur die Bewegung des Ziels in den bzw. aus dem Erfassungsbereich, nicht aber die Anwesenheit des Ziels in dem Erfassungsbereich in einem ruhenden Zustand detektiert. Detektiert der Sensor das Ziel, so kann er ein entsprechendes Signal abgeben.

Um die Lage des Sensors bei ansonsten vorgegebener Lage der gesamten Lagesensorvorrichtung justieren zu können, ist es erfindungsgemäß vorgesehen, den Sensor auf einem flexiblen Schaltungsträger anzuordnen, wobei er insbesondere mit Leiterbahnen des Schaltungsträgers elektrisch verbunden sein kann.

Unter flexiblen Schaltungsträgern werden dabei beliebige Schaltungsträger verstanden, die mit normalem Kraftaufwand durch eine Person wenigstens abschnittsweise biegbar sind. Beispielsweise können flexibelstarre Schaltungsträger mit flexiblen und starren Abschnitten verwendet werden. Vorzugsweise werden so genannte FFCs (Flexible Flat Circuits), FPCs (Flexible Printed Circuits) oder auch EFCs (Extruded Flat Circuits) eingesetzt, die gegebenenfalls in vorgegebenen Abschnitten mechanisch verstärkt sein können.

Durch entsprechende Anordnung des Sensors auf dem flexiblen Schaltungsträger und eine geeignete Anordnung und Ausbildung des flexiblen Schaltungsträgers kann der Sensor relativ zu der vorgegebenen Bahn unter Verbiegung des flexiblen Schaltungsträgers justiert werden.

Vorzugsweise besitzt die Lagesensorvorrichtung einen Träger, der die anderen Bauteile der Vorrichtung trägt und mittels dessen sie an einer anderen Einrichtung montierbar ist. Die vorgegebene Bahn kann dann vorzugsweise relativ zu dem Träger eine feste Lage einnehmen, sodass im Rahmen der Erfindung dann die Lage oder Bewegung des Sensors relativ zu der Bahn einer Lage bzw. Bewegung des Sensors relativ zu dem Träger entspricht.

Insbesondere kann beispielsweise ein Abschnitt des Schaltungsträgers an dem Träger oder einem Gehäuse der erfindungsgemäßen Vorrichtung direkt oder indirekt fest gehalten sein, wobei der Sensor immer noch einfach zur Justierung bewegbar ist.

Es genügt grundsätzlich, dass der Sensor entlang einer vorgegebenen Kurve, vorzugsweise näherungsweise entweder entlang der vorgegebenen Bahn oder quer zu dieser, bewegbar ist. In einigen Fällen kann jedoch eine Justierung in beiden Richtungen möglich und vorteilhaft sein. Weiterhin braucht der Sensor nur soweit beweglich zu sein, dass eine Justierung möglich ist, die häufig nur relativ kleine Bewegungen des Sensors erfordert.

Durch die Verwendung des flexiblen Schaltungsträgers ist es möglich, eine genaue Justierung des Sensors durchzuführen, ohne dass eine starre, mit Zuführungsleitungen verbundene Platine, auf der der Sensor angeordnet und gehalten ist, insgesamt bewegt werden muss. Insbesondere kann die Lagesensorvorrichtung als ganze relativ zu der vorgegebenen Bahn angeordnet werden, wobei zur genauen Justierung und zum Ausgleich von fertigungsbedingten Toleranzen in der Lage des Erfassungsbereichs des Sensors relativ zu dessen Gehäuse oder Träger nur noch der Sensor unter Verformung des flexiblen Schaltungsträgers bewegt zu werden braucht.

Weiterbildungen und bevorzugte Ausführungsformen der Erfindung sind in den Ansprüchen, der Beschreibung und den Zeichnungen beschrieben.

Für viele Anwendungen, insbesondere Anwendungen für Schalter, kann es erforderlich sein, festzustellen, ob das Ziel eine von zwei möglichen Lagen einnimmt bzw. erreicht. Es ist daher bevorzugt, dass wenigstens ein weiterer berührungslos arbeitender Sensor auf demselben flexiblen Schaltungsträger angeordnet ist, der auf eine Bewegung des Ziels in einem vorgegebenen Erfassungsbereich des weiteren Sensors und/oder aus diesem heraus oder auf die Anwesenheit des Ziels in dem vorgegebenen Erfassungsbereich des weiteren Sensors anspricht, und dass das Ziel in die Erfassungsbereiche der Sensoren bewegbar ist, wobei die Lage der Sensoren relativ zueinander und/oder der Bahn unter wenigstens teilweiser Verformung eines Abschnitts des Schaltungsträgers zwischen den Sensoren justierbar ist. Damit das Ziel in die Erfassungsbereiche beider Sensoren und gegebenenfalls darüber hinaus vorgesehener Sensoren bewegbar ist, überschneiden bei der Verwendung der erfindungsgemäßen Vorrichtung vorzugsweise die Erfassungsbereiche der Sensoren, d.h. wenigstens des Sensors und des weiteren Sensors sowie gegebenenfalls zusätzlicher Sensoren, die Bahn des Ziels. Auf diese Weise können auf einfache Weise Fertigungstoleranzen bei den Sensoren durch entsprechende Justierung ausgeglichen werden. Insbesondere können Toleranzen in der Lage der Erfassungsbereiche relativ zu Sensorgehäusen oder -trägern der Sensoren, die darauf zurückzuführen sind, dass die eigentlichen Sensorelemente relativ zu den Sensorgehäusen relativ große Lage- bzw. Orientierungstoleranzen aufweisen, einfach kompensiert werden. Bei einer Anordnung der beiden oder mehrerer Sensoren auf einer einzigen starren Platine ist eine solche Justierung nicht möglich, wodurch sich sehr große Erfassungstoleranzen ergeben. Der weitere Sensor bzw. weitere Sensoren kann bzw. können von dem ersten Sensor verschieden sein, vorzugsweise handelt es sich jedoch um einen Sensor bzw. Sensoren des gleichen Typs.

Grundsätzlich können erfindungsgemäß beliebige berührungslos arbeitende Sensoren verwendet werden. Beispielsweise können kapazitiv arbeitende Sensoren verwendet werden. Bei einer bevorzugten Ausführungsform der Erfindung ist der Sensor ein Magnetsensor. Darunter werden alle Sensoren verstanden, die auf das Vorhandensein von Magnetfeldern bzw. die Änderung von Magnetfeldern ansprechen. Die Magnetfelder können dabei von einem Magneten des Sensors erzeugt und beispielsweise durch ein weichmagnetisches Ziel verändert werden. Es können jedoch als Ziel auch Magnete verwendet werden. Insbesondere können magnetoresistive oder auch induktiv arbeitende Sensoren verwendet werden. Das Ziel ist dann so ausgebildet, dass es von dem jeweiligen Sensor erfassbar ist.

Um eine möglichst hohe Ortsauflösung zu erhalten, ist es bevorzugt, dass der Sensor ein optoelektronisches Empfangselement aufweist. Hierbei wird ausgenutzt, dass optische Strahlung, d.h. Strahlung mit Wellenlängen im Bereich zwischen dem Infrarotbereich und dem Ultraviolettbereich des elektromagnetischen Spektrums, sich für typische Größen des Ziels im Wesentlichen strahlförmig ausbreitet und daher sehr schmale Erfassungsbereiche erhalten werden können.

Besonders bevorzugt umfasst der Sensor eine Lichtschranke oder einen Lichttaster. In diesem Fall ist also neben einem optoelektronischen Empfangselement auch eine Strahlungsquelle für optische Strahlung vorgesehen, mittels derer optische Strahlung abgebbar ist, die von dem optoelektronischen Empfangselement, gegebenenfalls nach Reflexion an dem Ziel oder einem reflektierenden Bauelement der Lichtschranke oder des Lichttasters, empfangbar ist. Durch entsprechende Bündelung der optischen Strahlung kann so eine sehr hohe Ortsauflösung erreicht werden. Darüber hinaus braucht das Ziel keine besonderen mechanischen Eigenschaften aufzuweisen. Es genügt, dass das Ziel die optische Strahlung, je nach Ausbildung des Sensors, entweder reflektiert oder nicht oder nur hinreichend stark geschwächt durchlässt.

Um eine Bewegung des Sensors zur Justierung in zwei entgegengesetzten Richtungen zu ermöglichen, ist es bevorzugt, dass der flexible Schaltungsträger wenigstens einen gewölbten Ausgleichsabschnitt aufweist, dessen Form durch Bewegung des Sensors relativ zu der vorgegebenen Bahn änderbar ist. Je nach Bewegungsrichtung des Sensors kann dabei die Wölbung bzw. Krümmung des Ausgleichsabschnitts vergrößert oder reduziert werden.

Je nach Typ des Sensors, beispielsweise bei solchen, die Lichtschranken oder Lichttaster umfassen, ist eine Justierung in einer Richtung quer zu der vorgegebenen Bahn nicht unbedingt notwendig, sondern nur eine entlang der vorgegebenen Bahn. Es ist dann bevorzugt, dass der flexible Schaltungsträger so ausgebildet ist, dass der Sensor im Wesentlichen entlang der vorgegebenen Bahn des von dem Sensor erfassbaren Ziels bewegbar ist. Weist der Schaltungsträger beispielsweise den in dem vorhergehenden Absatz genannten Ausgleichsabschnitt auf, so erstreckt sich die Wölbung vorzugsweise quer zur vorgegebenen Bahn, so dass durch Änderung des Wölbungs- bzw. Krümmungsradius eine Verschiebung entlang der Bahn ermöglicht wird. Dies erleichtert die Justierung dadurch, dass Bewegungen entlang der Bahn unter nur geringem Kraftaufwand möglich sind und dass, bei geeigneter Ausführung des Ausgleichsabschnitts, nicht notwendige bzw. erwünschte Bewegungen quer zu der Bahn nur unter höherem Kraftaufwand möglich sind.

Obwohl der Sensor grundsätzlich auf dem flexiblen Schaltungsträger angeordnet und auch gehalten ist und damit eine Bewegung des Sensors durch Bewegung des entsprechenden Abschnitts des Schaltungsträgers erfolgen könnte, ist es bevorzugt, dass der Sensor in einer Aufnahme sitzt, die bewegbar in oder an einem Träger der Vorrichtung gehalten ist. Die Aufnahme kann dabei unmittelbar oder mittels weiterer Elemente an dem Träger gehalten sein. Auf diese Weise kann zu Justierungszwecken die Aufnahme und mit dieser der Sensor bewegt werden. Weiterhin können Kräfte auf den Sensor von der Aufnahme aufgenommen werden, so dass eine Ermüdung oder gar Beschädigung der Verbindung des Sensors mit dem flexiblen Schaltungsträger weitgehend vermieden werden kann. Auch kann eine Beschädigung des Sensors dadurch weitgehend ausgeschlossen werden. Darüber hinaus kann die Aufnahme auch für Justierungszwecke geeignet gestaltet werden, während der Sensor handelsüblich ausgebildet sein kann und nicht speziell zur Verwendung in der erfindungsgemäßen Lagesensorvorrichtung ausgebildet zu sein braucht.

Um die Bewegung des Sensors bei der Justierung einfach besonders kontrolliert ausführen zu können und damit eine sehr genaue Justierung zu ermöglichen, ist es bevorzugt, dass eine Führung vorgesehen ist, mittels derer der Sensor relativ zu der Bahn führbar ist. Dabei kann die Führung insbesondere auch die bereits erwähnte Aufnahme umfassen, die dann selbst entsprechend geführt bewegbar ist.

Um zu vermeiden, dass von dem flexiblen Schaltungsträger größere, auf den Sensor ausgeübte Kräfte aufgenommen werden müssen, ist es bevorzugt, dass der Sensor an wenigstens einem flexiblen Element gehalten ist. Dabei kann das flexible Element insbesondere die bereits erwähnte Aufnahme für den Sensor umfassen. Vorzugsweise wird als flexibles Element ein flexibler Arm verwendet. Durch die Flexibilität wird eine Bewegung des Sensors zur Justierung ermöglicht. Gleichzeitig wird jedoch eine völlig beliebige Verschiebung des Sensors unterbunden, was eine Justierung deutlich erleichtern kann. Das flexible Element kann insbesondere auch elastisch sein.

Damit der Sensor nach durchgeführter Justierung auch bei Erschütterungen der Vorrichtung in der justierten Lage verbleibt, ist es bevorzugt, dass eine Sicherungseinrichtung vorgesehen ist, mittels derer der Sensor in einer justierten Lage sicherbar ist. Dabei kann die Sicherungseinrichtung unmittelbar auf den Sensor wirken, bevorzugt wirkt sie jedoch alternativ oder zusätzlich auf den Abschnitt des flexiblen Schaltungsträgers, auf dem der Sensor angeordnet ist, und/oder die Aufnahme, wenn der Sensor in einer solchen sitzt, und/oder ein anderes den Sensor haltendes Element. Es genügt, wenn die Sicherungseinrichtung eine Dejustierung durch kleinere Kräfte, beispielsweise Schwingungen und gebrauchstypische Erschütterungen in einem Kraftfahrzeug, einem Motor oder einer anderen Vorrichtung bzw. Umgebung, in der die Sensorvorrichtung verwendet wird, verhindert. Eine Bewegung des Sensors mit größeren Kräften kann jedoch gegebenenfalls noch möglich sein.

Grundsätzlich können beliebige Sicherungseinrichtungen verwendet werden. Es ist jedoch bevorzugt, dass die Sicherungseinrichtung eine Klemmeinrichtung aufweist, mittels derer wenigstens der Abschnitt des flexiblen Schaltungsträgers, auf dem der Sensor angeordnet ist, und/oder der Sensor und/oder die Aufnahme in seiner bzw. ihrer Lage relativ zu einem Träger der Vorrichtung festlegbar ist. Sie ermöglicht eine besonders einfache Sicherung des Sensors in seiner Lage. Darüber hinaus kann die Klemmkraft so eingestellt werden, dass eine Sicherung gegenüber gebrauchstypischen Erschütterungen erreicht wird, ein Justierung unter Verwendung entsprechender Kräfte jedoch möglich bleibt.

Es ist dabei bevorzugt, dass die Klemmeinrichtung eine an einem Träger schwenkbar gehaltene Klappe umfasst. Insbesondere in dem Fall, dass der Träger aus Kunststoff im Spritzgussverfahren gefertigt ist, kann die Klappe durch ein Filmscharnier mit dem Träger verbunden sein. Vorzugsweise ist der Träger mit der Klappe dabei so ausgebildet, dass im geklemmten Zustand die Klappe und der Träger den flexiblen Schaltungsträger von zwei gegenüberliegenden Seiten umschließen. Die Klappe kann dann gleichzeitig als Teil eines Deckels bzw. Gehäuses der erfindungsgemäßen Vorrichtung dienen.

Weiterhin ist es besonders bevorzugt, dass die Klappe mittels einer Rast- und/oder Schraubverbindung verriegelbar ist. Dadurch kann verhindert werden, dass sich im Laufe der Zeit die Sicherung des Sensors beispielsweise durch Erschütterungen selbsttätig löst. Darüber hinaus kann die Klemmkraft erhöht werden.

Grundsätzlich genügt es bei der erfindungsgemäßen Lagesensorvorrichtung, dass diese insgesamt relativ zu der vorgegebenen Bahn des Ziels angeordnet werden kann. Insbesondere kann sie dazu einen Träger umfassen, auf dem alle Elemente der Lagesensorvorrichtung angeordnet sind. Dabei kann dann der flexible Schaltungsträger mit einem Abschnitt an dem Träger oder einem damit verbundenen Teil festgelegt sein, sodass eine Justierung des Sensor unter Bewegung relativ zu dem Träger erfolgt, wobei der Schaltungsträger zwischen dem Sensor und dem Festlegungsbereich wenigstens teilweise verformt wird.

Für viele Anwendungen ist es jedoch bevorzugt, dass der Körper an einem Träger der Lagesensorvorrichtung beweglich gelagert ist. Mittels der Lagesensorvorrichtung ist dann eine Lage des Körpers ermittelbar, die beispielsweise durch eine dem Körper aufgeprägte Bewegung veränderbar sein kann.

Das Ziel bzw. der Körper kann auf einer beliebigen vorgegebenen Bahn bewegbar sein. Vorzugsweise kann es linear verschiebbar sein. In diesem Fall kann einfach die Lage bei einer in vielen Fällen auftretenden linearen Bewegung erfasst werden.

Es ist für andere Anwendungen bevorzugt, dass der Körper dreh- oder schwenkbar gelagert ist, so dass das Ziel entlang eines Kreisbogens als vorgegebener Bahn bewegbar ist. Eine solche Lagesensorvorrichtung eignet sich insbesondere zur Detektion von Dreh- oder Schwenkbewegungen.

Eine erfindungsgemäße Lagesensorvorrichtung kann insbesondere zur Herstellung von elektronischen Schaltern verwendet werden. Gegenstand der vorliegenden Erfindung ist daher auch ein Schalter mit einer erfindungsgemäßen Lagesensorvorrichtung, bei der der Körper als Betätigungselement oder Koppelglied ausgebildet ist. Eine Bedienperson kann unmittelbar an dem Betätigungselement angreifen. Bei Ausbildung des Körpers als Koppelglied dagegen kann das Koppelglied eine Bewegung beispielsweise eines Betätigungsgliedes in eine Bewegung des Ziels umsetzen. Der Schalter kann weiterhin eine Schaltung umfassen, mittels derer in Abhängigkeit von Signalen des Sensors zwei Anschlüsse elektrisch miteinander verbunden oder voneinander getrennt oder Schaltsignale gebildet werden können.

Die Erfindung wird im Folgenden noch weiter anhand der Zeichnungen beispielhaft erläutert. Es zeigen:
- Fig. 1: eine schematische Explosionsdarstellung eines Schalters mit einer Lagesensorvorrichtung nach einer bevorzugten Ausführungsform der Erfindung,
- Fig. 2: eine Schnittdarstellung durch den Schalter bzw. die Vorrichtung in Fig. 2 entlang einer Längsachse und in einem justierten und gesicherten Zustand,
- Fig. 3: eine perspektivische Ansicht eines Schaltstücks der Vorrichtung in Fig. 1,
- Fig. 4: eine schematische Schnittansicht durch einen Halter der Vorrichtung in Fig. 1 mit zwei Aufnahmen,
- Fig. 5: eine schematische vergrößerte perspektivische Ansicht des Schaltstücks in Fig. 3 mit zwei Lichtschranken,
- Fig. 6: eine teilweise, schematische Ansicht eines flexiblen Schaltungsträgers der Vorrichtung in Fig. 1 mit zwei Lichtschranken,
- Fig.7: eine schematische Darstellung der Vorrichtung in Fig. 1 in einem teilweise zusammengesetzten Zustand, bei dem eine Sicherungsklappe noch nicht geschlossen ist, und
- Fig. 8: eine schematische teilweise Ansicht der Vorrichtung in Fig. 1 von unten nach Schließen der Sicherungsklappe.

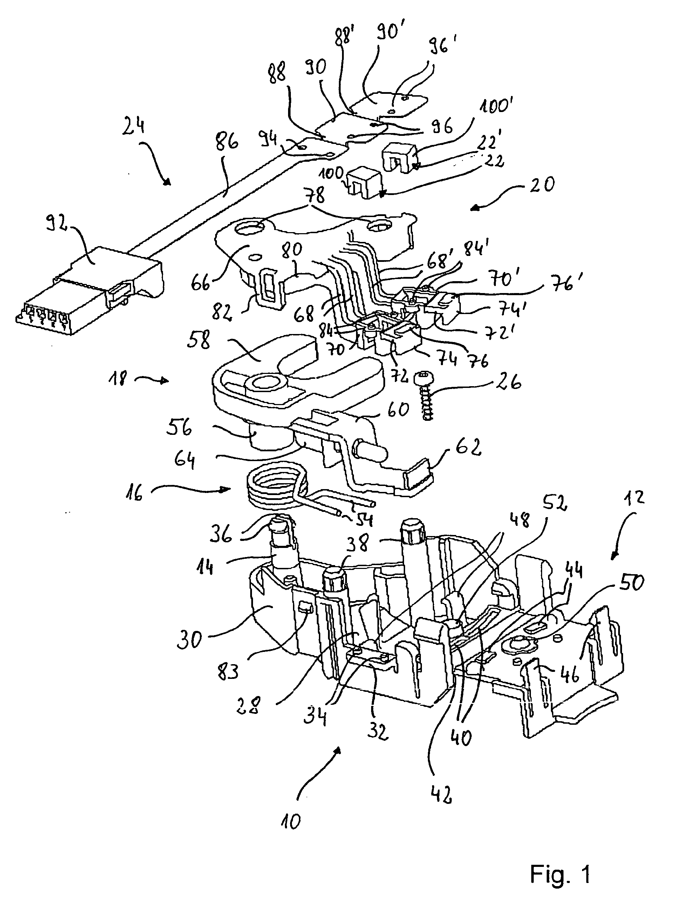

In den Fig. 1 bis 8 umfasst ein Schalter mit einer Lagesensorvorrichtung nach einer bevorzugten Ausführungsform der Erfindung einen Träger 10 mit einer Sicherungsklappe 12, eine von einem Lagerzapfen 14 des Trägers 10 durchsetzte Schenkelfeder 16, ein auf dem Lagerzapfen 14 schwenkbar gelagertes Schaltstück 18, einen Halter 20, Lichtschranken 22 und 22' sowie einen flexiblen Schaltungsträger 24. Weiterhin ist eine Verriegelungsschraube 26 vorgesehen.

Der Träger 10, der wie auch das Schaltstück 18 und der Halter 20 als Spritzgussteil aus einem geeigneten Kunststoff gefertigt ist, trägt die oben genannten Teile des Schalters und dient gleichzeitig als Gehäuseunterteil, wozu er neben dem Boden 28 eine U- bzw. V-förmig umlaufende Gehäusewand 30 aufweist. Ein Abschnitt der Gehäusewand 30 weist an einer Ausnehmung einen Vorsprung 32 mit Zugentlastungszapfen 34 auf. Der flexible Schaltungsträger 24 wird durch die Ausnehmung in den Träger 10 geführt, wobei die Zugentlastungszapfen 34 zur Zugentlastung des auf dem Vorsprung 32 aufliegenden flexiblen Schaltungsträgers dienen.

Der Lagerzapfen 14 dient zum einen zur schwenkbaren Lagerung des Schaltstücks 18 und zum anderen der Befestigung des Halters 20. Dazu weist er an seinem freien Ende zwei federnde Restnasen 36 auf, mittels derer der Halter 20 mit dem Träger 10 verrastbar ist.

Der Träger 10 weist weiterhin zwei Haltezapfen 38 auf, die zur Positionierung des Halters 20 dienen.

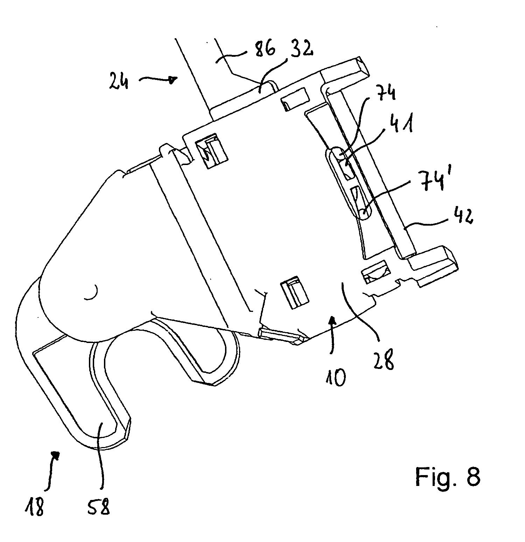

In dem Boden 28 des Trägers 10 sind Führungsnuten 40 in einer Rippe des Bodens 28 ausgebildet, die sich entlang eines Kreisbogens um den Lagerzapfen 14 erstrecken. Durch einen nur in Fig. 8 sichtbaren Schlitz 41 sind die Führungsnuten 40 von der Unterseite des Trägers 10 her wenigstens teilweise zugänglich.

Die Sicherungsklappe 12 ist über ein Filmgelenk 42 schwenkbar an dem Träger 10 gehalten und weist zum einen Klemmvorsprünge 44 und zum anderen Rastzungen 46, die mit komplementären Rastelementen 48 auf dem Boden 28 des Trägers 10 verrastbar sind, auf. Weiterhin ist ein Durchgangsloch 50 vorgesehen, das nach Schwenken der Sicherungsklappe 12 in das Innere des Trägers 10 mit einem in dem Boden 28 angeordneten Aufnahmeloch 52 für die Verriegelungsschraube 26 fluchtet.

Die Schenkelfeder 16 weist zwei sich überkreuzende Schenkel 54 auf, die mittels des Schaltstücks 18 auslenkbar sind. In den Figuren nicht sichtbare Anschläge für die Schenkel 54 auf dem Boden 28 verhindern eine Drehung der Schenkelfeder 16, wenn auf die Schenkel 54 Kräfte ausgeübt werden.

Das Schaltstück 18 (vgl. Fig. 1, 2 und 3), das einen Körper bzw. Koppelglied im Sinne der Erfindung darstellt, weist einen Hülsenabschnitt 56 an einer U-förmigen Platte 58 auf, mittels dessen das Schaltstück 18 auf dem Lagerzapfen 14 dreh- bzw. schwenkbar gelagert ist, wobei der Hülsenabschnitt 56 durch die Schenkelfeder 16 greift. An einem gekröpften ersten Arm 60 ist als Ziel eine sich entlang der Schwenkrichtung erstreckende Wand 62 ausgebildet. Unterhalb des ersten Arms 60 befindet sich ein zweiter Arm 64. Die Arme 60 und 64 sind dabei relativ zu der Schenkelfeder 16 so angeordnet, dass diese bei Schwenkung des Schaltstücks 18 um den Lagerzapfen 14 jeweils einen der Schenkel 54, je nach Schwenkrichtung, nach außen gegen eine rückstellende Federkraft auslenken.

Der Halter 20 (vgl. Fig. 1, 2 und 4) dient gleichzeitig als Deckel für den Träger 10 und Halter für die Lichtschranken 22 und 22'. Er weist an einem plattenförmigen Deckelabschnitt 66 an je zwei federnden Armen 68 bzw. 68' Aufnahmen 70 bzw. 70' für die Lichtschranken 22 bzw. 22' auf. An den Aufnahmen 70 bzw. 70' sind parallel zu dem Deckelabschnitt 66 verlaufende Vorsprünge 72 und 72' mit entlang eines Kreisbogens und parallel zu dem Lagerzapfen 14 verlaufenden Führungsfedern 74 bzw. 74' sowie Klemmvorsprüngen 76 bzw. 76' ausgebildet.

Der Deckelabschnitt 66 besitzt Zapfenlöcher 78 sowie eine Zapfenausnehmung 80, durch die der Lagerzapfen 14 bzw. die Haltezapfen 38 führbar sind, so dass der Deckelabschnitt 66 teilweise als Deckel für den Träger 10 dient. Der Halter 20 ist über eine federnde Rastlasche 82 und ein entsprechendes komplementäres Rastelement 83 an der Gehäusewand 30 und über die Rastnasen 14 an dem Haltezapfen 14 mit dem Träger 10 verrastbar. Er sichert damit das Schaltstück 18 gegen Bewegungen in einer Richtung parallel zu dem Lagerzapfen 14 bzw. der dadurch definierten Schwenkachse.

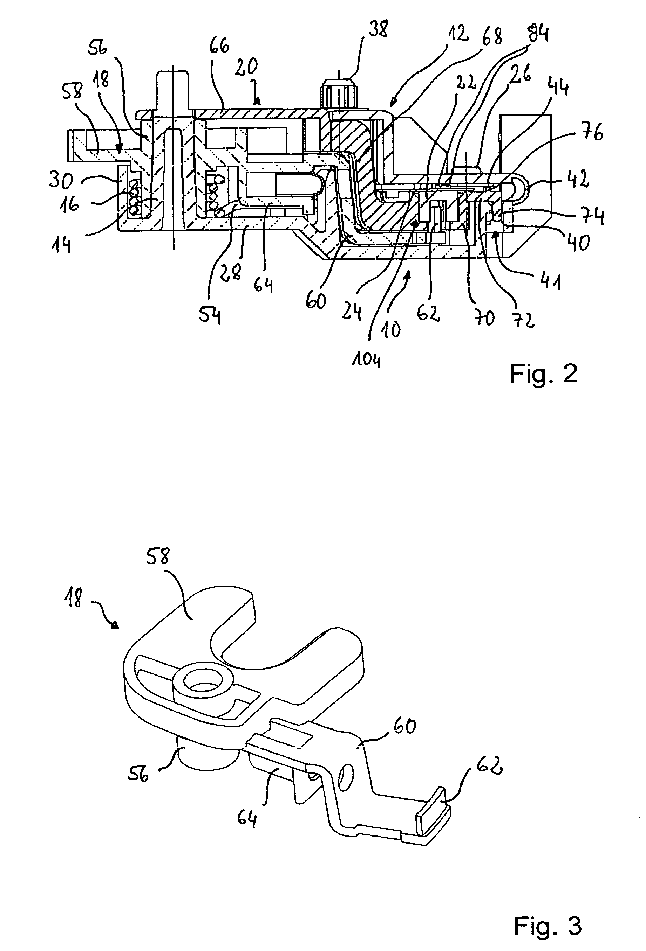

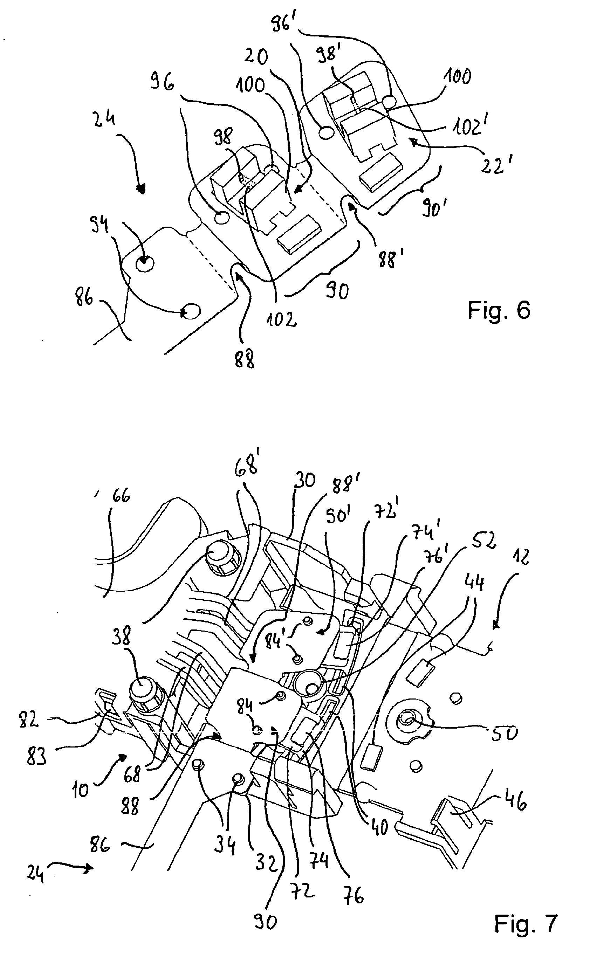

Die Führungsfedern 74 bzw. 74' sind so angeordnet und ausgebildet, dass sie in den Führungsnuten 40 in dem Träger 10 entlang eines Kreisbogens um den Lagerzapfen 14 unter entsprechender Verformung der federnden Arme 68 bzw. 68' bewegbar sind (vgl. Fig. 2 und 7). Damit wird gleichzeitig eine Führung der Bewegung der Ausnahmen 70 und 70' und der darin aufgenommenen Sensoren bzw. Lichtschranken 22 und 22' erreicht.

Die Klemmvorsprünge 76 und 76' sind so ausgebildet und angeordnet, dass sie bei Schwenken der Sicherungsklappe 12 in eine Sicherungsposition mit den Klemmvorsprüngen 44 an der Sicherungsklappe 12 entsprechende Abschnitte des flexiblen Schaltungsträgers 24 einklemmen.

An den Aufnahmen 70 und 70' sind weiterhin jeweils Positionierungszapfen 84 bzw. 84' vorgesehen, die zur Festlegung von Abschnitten des flexiblen Schaltungsträgers 24 dienen.

Der flexible Schaltungsträger 24, im Ausführungsbeispiel ein FPC, besitzt einen Zuleitungsabschnitt 86, der über einen ersten gewölbten Ausgleichsabschnitt 88 in einen ersten Lichtschrankenabschnitt 90 übergeht, an den sich über einen zweiten gewölbten Ausgleichsabschnitt 88' ein zweiter Lichtschrankenabschnitt 90' anschließt (vgl. Fig. 6). Das freie Ende des Zuleitungsabschnitts 26 ist mit einem Steckverbinder 92 verbunden, dessen Kontaktelemente zur Verbindung von Leiterbahnen in dem flexiblen Schaltungsträger 24 mit Zuleitungen für den Schalter verbunden sind.

Am Ende des Zuleitungsabschnitts 86 nahe dem ersten Ausgleichsabschnitts 88 sind zwei Löcher 94 vorgesehen, durch die die Zapfen 34 an dem Träger 10 geführt werden können, um eine Positionierung und eine Zugentlastung für den flexiblen Schaltungsträger 24 zu erreichen.

Wie in den Fig. 1 und 6 erkennbar, besitzen die Lichtschrankenabschnitte 90 und 90' Löcher 96 bzw. 96', durch die die Positionierungszapfen 84 bzw. 84' der Aufnahmen 70 bzw. 70' geführt werden können, um eine Positionierung und Sicherung der Lichtschrankenabschnitte über den Aufnahmen 70 bzw. 70' zu ermöglichen.

Die Lichtschrankenabschnitte 90 bzw. 90' dienen zum Anschluss der auf diesen angeordneten Lichtschranken 22 bzw. 22'.

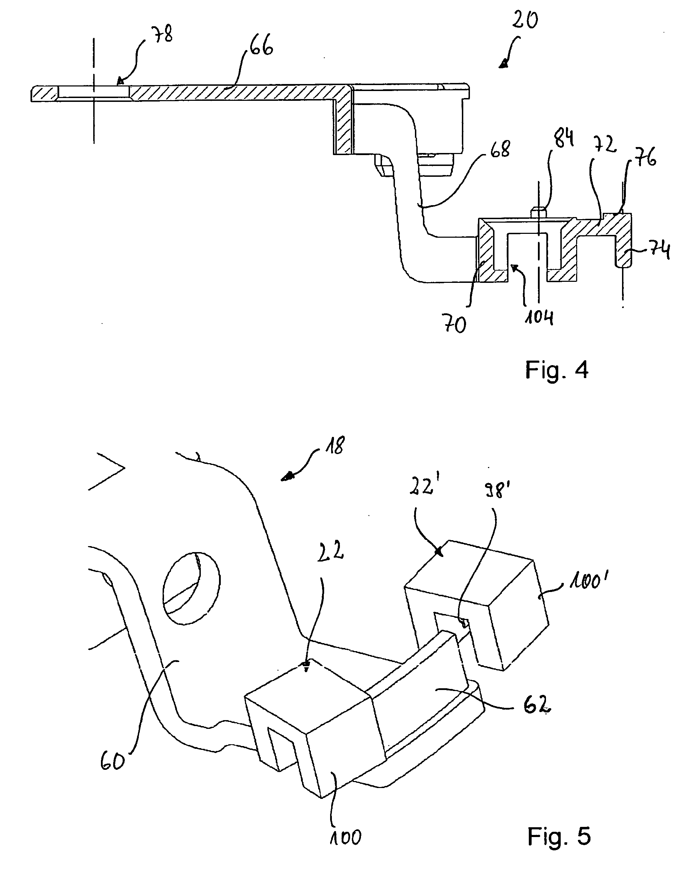

Die gleich ausgebildeten Lichtschranken 22 und 22' verfügen jeweils über eine Strahlungsquelle 98 bzw. 98' für optische Strahlung, beispielsweise eine Leuchtdiode, und, in den Figuren nicht sichtbar, ein Sensorelement, die in sich gegenüberliegenden Schenkeln einer U-förmigen Halterung 100 bzw. 100' angeordnet sind. Die U-förmigen Halterungen 100 bzw. 100' bilden in den Lichtschranken 22 und 22' Längskanäle, durch die, wie in Fig. 5 sichtbar, die Wand 62 des Schaltstücks 18 als Ziel bewegbar ist. Die in der Fig. 6 nur sehr schematisch angedeuteten Erfassungsbereiche 102 bzw. 102' der als Sensoren im Sinne der Erfindung aufzufassenden Lichtschranken 22 und 22' verlaufen als schmale Balken quer zu der kreisbogenförmigen Bahn der Wand 62, die das zu erfassende Ziel darstellt.

Die Ausgleichsabschnitte 88 und 88' sind so gewölbt, dass die Sensoren bzw. Lichtschranken 22 bzw. 22' wenigstens entlang der kreisbogenförmigen Bahn der Wand 62 relativ zueinander und insbesondere auch relativ zu dem Zuleitungsabschnitt 86 bzw. dem Träger 10 bewegbar sind.

Der Zusammenbau des erfindungsgemäßen Schalters erfolgt folgendermaßen:

Zunächst wird die Schenkelfeder 16 an dem Schaltstück 18 vormontiert, indem sie so über den Hülsenabschnitt 56 des Schaltstücks 18 geführt wird, dass die Arme 60 bzw. 64 an den Schenkeln 54 der Schenkelfeder 16 anliegen.

Daraufhin wird das Schaltstück 18 mit dem Hülsenabschnitt 56 und der an diesem montierten Schenkelfeder 16 auf den Lagerzapfen 14 gesteckt, wobei die Sicherungsklappe 12 des Träger 10 in einer geöffneten Stellung (vgl. Fig. 1) angeordnet ist. Die auf dem Boden 28 des Trägers 10 angeordneten, in den Figuren nicht sichtbaren Anschläge liegen dabei an den Schenkeln 54 der Schenkelfeder 16 an und verhindern eine Drehung der Schenkelfeder 16.

Daraufhin wird der Halter 20 auf den Lagerzapfen 14 sowie die Haltezapfen 38 gesteckt und hinter den Rastnasen 36 verrastet. Weiterhin erfolgt eine Verrastung über die Rastlasche 82 und das entsprechende komplementäre Rastelement 83.

Die Lichtschranken 22 und 22' werden auf dem flexiblen Schaltungsträger 24 in den Lichtschrankenabschnitten 90 und 90' befestigt und mit entsprechenden Leiterbahnen kontaktiert.

Der flexible Schaltungsträger 24 wird sodann auf den Träger 10 und die Aufnahmen 70 und 70' des Halters 20 gelegt, so dass die Zapfen 34 des Träger 10 durch die Löcher 94 in dem Zuleitungsabschnitt 86 und die Positionierungszapfen 84 und 84' der Aufnahmen 70 und 70' durch die entsprechenden Löcher 96 und 96' in den Lichtschrankenabschnitten 90 bzw. 90' greifen. Die Lichtschranken 22 und 22' werden dabei formschlüssig in Kammern 104 bzw. 104' der Aufnahmen 70 bzw. 70' formschlüssig aufgenommen (vgl. Fig. 2 und 7).

Die Sensoren bzw. Lichtschranken 22 bzw. 22' sind daher mittels der an den federnden Armen 68 und 68' des Halters 20 gehaltenen Aufnahmen bewegbar an dem Träger 10 gehalten und durch die federnden, flexiblen Arme 68 und 68' sowie die in den Führungsnuten 40 geführten Führungsfedern 74 und 74' entlang eines Kreisbogens um den Lagerzapfen 14 und damit der Bahn des Ziels bzw. der Wand 62 geführt. Die Ausgleichsabschnitte 88 und 88' sind in diesem Stadium gewölbt, sodass die Aufnahmen 70, 70' mit den Sensoren 22 bzw. 22' relativ zueinander und zu dem Vorsprung 32 bzw. dem Träger 10 in zwei entgegengesetzten Richtungen bewegbar sind.

Die Sicherungsklappe 12 wird dann in Richtung auf den flexiblen Schaltungsträger 24 hin umgeklappt und mittels der Rastzungen 46 und der entsprechenden komplementären Rastelemente 48 verrastet. Dabei pressen die Klemmvorsprünge 44 auf die entsprechenden Klemmvorsprünge 76 bzw. 76' des Halters 20, so dass die an den federnden Armen 68 bzw. 68' gehaltenen Aufnahmen 70 bzw. 70' und damit die darin aufgenommenen Lichtschranken 22 bzw. 22' über Reibschluss fixiert werden. Die Klemmvorsprünge können zur Verbesserung der Wirkung kleine Rippen- oder Waffelmuster aufweisen.

Zur Justierung werden bei einer Endkontrolle die Aufnahmen 70 bzw. 70' an den federnden Armen 68 bzw. 68' mittels beispielsweise eines durch den Schlitz 41 (vgl. Fig. 8) geführten Dorns, der an den Führungsfedern 74 bzw. 74' angreift, in eine vorgegebene Justierposition bewegt, wobei die Aufnahmen 70 bzw. 70' mittels der Führungsfedern 74 und 74' in den Führungsnuten 40 geführt auf dem Träger 10 gleiten. Da der flexible Schaltungsträger 24 mit dem Zuleitungsabschnitt mittels der Löcher 94 und den Zugentlastungszapfen 34 an dem Träger und damit auch der Bahn des Ziels bzw. der Wand 62 festgelegt ist, kann die Lage der Sensoren relativ zu der Bahn bzw. dem Träger 10 und auch zueinander justiert werden. Als Vorgabe für die Justierung kann dienen, dass in zwei vorgegebenen Schwenklagen des Schaltstücks 18 jeweils eine der Lichtschranken 22 und 22' durch das Ziel bzw. die Wand 62 unterbrochen wird.

Zum Schluss wird die Klemmung durch Eindrehen der Verriegelungsschraube 26 durch das Durchgangsloch 50 in das Aufnahmeloch 52 gedreht, um die Sicherungsklappe 12 in ihrer Position zu verriegeln und gleichzeitig die Klemmwirkung zu verbessern.

Bei einer Verwendung als Schalter wird das Schaltstück 18 zwischen zwei Positionen hin- und hergeschwenkt, wobei zum einen jeweils einer der Schenkel 54 durch den entsprechenden Arm 60 bzw. 64 gegen die rücktreibende Federkraft ausgelenkt wird. Zum anderen wird die Wand 62 als Ziel in einen der Erfassungsbereiche 102 bzw. 102' der Sensoren bzw. Lichtschranken 22 oder 22' entlang eines Kreisbogens bewegt, was durch die entsprechenden Lichtschranken unter Abgabe eines Detektionssignals detektiert wird. Die Wand 62 stellt damit ein Ziel im Sinne der vorliegenden Erfindung dar, das auf einer vorgegebenen Bahn, hier eine Kreisbahn um den Lagerzapfen 14 bewegbar ist.

Wird keine Kraft bzw. kein Drehmoment auf das Schaltstück 18 ausgeübt, wird es durch den ausgelenkten Schenkel 54 der Schenkelfeder 16 wieder in eine Ruhestellung zurückgeführt, in der das Ziel bzw. die Wand 62 in keinem der Erfassungsbereiche 102 bzw. 102' positioniert ist (vgl. Fig. 5).

Durch die Justierung der Lage der Lichtschranken 22 und 22' kann sehr genau der Schaltpunkt, das heißt die für ein Auslösen eines Schaltvorgangs bzw. -signals notwendige Auslenkung des Schaltstücks 18, definiert werden, bei dem ein Eintreten der Wand bzw. des Ziels 62 in den jeweiligen Erfassungsbereich detektiert und damit ein Schaltvorgang ausgelöst wird.

### Bezugszeichenliste

- 10: Träger
- 12: Sicherungsklappe
- 14: Lagerzapfen
- 16: Schenkelfeder
- 18: Schaltstück
- 20: Halter
- 22, 22': Lichtschranken
- 24: flexibler Schaltungsträger
- 26: Verriegelungsschraube
- 28: Boden
- 30: Gehäusewand
- 32: Vorsprung
- 34: Zugentlastungszapfen
- 36: Rastnasen
- 38: Haltezapfen
- 40: Führungsnuten
- 41: Schlitz
- 42: Filmgelenk
- 44: Klemmvorsprünge
- 46: Rastzungen
- 48: komplementäre Rastelemente
- 50: Durchgangsloch
- 52: Aufnahmeloch
- 54: Schenkel
- 56: Hülsenabschnitt
- 58: U-förmige Platte
- 60: erster Arm
- 62: Wand
- 64: zweiter Arm
- 66: Deckelabschnitt
- 68, 68': federnde Arme
- 70, 70': Aufnahmen
- 72, 72': Vorsprünge
- 74, 74': Führungsfedern
- 76, 76': Klemmvorsprünge
- 78: Zapfenlöcher
- 80: Zapfenausnehmung
- 82: Rastlasche
- 83: komplementäres Rastelement
- 84, 84': Positionierungszapfen
- 86: Zuleitungsabschnitt
- 88, 88': Ausgleichsabschnitte
- 90, 90': Lichtschrankenabschnitte
- 92: Steckverbinder
- 94: Löcher
- 96, 96': Löcher
- 98, 98': Strahlungsquellen
- 100, 100': Halterungen
- 102, 102': Erfassungsbereiche
- 104, 104': Kammern

## Patentansprüche

1. Lagesensorvorrichtung zur Detektion der Lage eines auf einer vorgegebenen Bahn bewegbaren, durch einen Körper (18) oder einen Abschnitt eines Körpers (18) gegebenen Ziels (62) mit
einem flexiblen Schaltungsträger (24) und
wenigstens einem auf dem Schaltungsträger (24) angeordneten, berührungslos arbeitenden Sensor (22, 22'), der auf eine Bewegung des Ziels (62) in einen vorgegebenen Erfassungsbereich (102, 102') des Sensors (22, 22') und/oder aus diesem heraus oder auf die Anwesenheit des Ziels (62) in dem vorgegebenen Erfassungsbereich (102, 102') anspricht und dessen Lage zur Justierung relativ zu der vorgegebenen Bahn unter wenigstens teilweiser Verformung des Schaltungsträgers (24) veränderbar ist.

2. Lagesensorvorrichtung nach Anspruch 1,
**dadurch gekennzeichnet,**
**dass** wenigstens ein weiterer berührungslos arbeitender Sensor (22, 22') auf demselben flexiblen Schaltungsträger (24) angeordnet ist, der auf eine Bewegung des Ziels (62) in einen vorgegebenen Erfassungsbereich (102, 102') des weiteren Sensors (22, 22') und/oder aus diesem heraus oder auf die Anwesenheit des Ziels (62) in dem vorgegebenen Erfassungsbereich (102, 102') des weiteren Sensors (22, 22') anspricht, und
**dass** das Ziel (62) in die Erfassungsbereiche (102, 102') der Sensoren (22, 22') bewegbar ist, wobei die Lage der Sensoren (22, 22') relativ zueinander und/oder der Bahn unter wenigstens teilweiser Verformung eines Abschnitts (88, 88') des Schaltungsträgers (24) zwischen den Sensoren (22, 22') justierbar ist.

3. Lagesensorvorrichtung nach Anspruch 1 oder 2,
**dadurch gekennzeichnet,**
**dass** der Sensor ein Magnetsensor ist.

4. Lagesensorvorrichtung nach Anspruch 1 oder 2,
**dadurch gekennzeichnet,**
**dass** der Sensor (22, 22') ein optoelektronisches Empfangselement aufweist.

5. Lagesensorvorrichtung nach Anspruch 4,
**dadurch gekennzeichnet,**
**dass** der Sensor (22, 22') eine Lichtschranke oder einen Lichttaster umfasst.

6. Lagesensorvorrichtung nach einem der vorhergehenden Ansprüche,
**dadurch gekennzeichnet,**
**dass** der flexible Schaltungsträger (24) wenigstens-einen-gewölbten Ausgleichsabschnitt (88, 88') aufweist, dessen Form durch Bewegung des Sensors (22, 22') relativ zu der vorgegebenen Bahn änderbar ist.

7. Lagesensorvorrichtung nach einem der vorhergehenden Ansprüche,
**dadurch gekennzeichnet,**
**dass** der flexible Schaltungsträger (24) so ausgebildet ist, dass der Sensor (22, 22') im Wesentlichen entlang der vorgegebenen Bahn des von dem Sensor (22, 22') erfassbaren Ziels (62) bewegbar ist.

8. Lagesensorvorrichtung nach einem der vorhergehenden Ansprüche,
**dadurch gekennzeichnet,**
**dass** der Sensor (22, 22') in einer Aufnahme (70, 70') sitzt, die bewegbar in oder an einem Träger (10) der Vorrichtung gehalten ist.

9. Lagesensorvorrichtung nach einem der vorhergehenden Ansprüche,
**gekennzeichnet durch**
eine Führung (40, 70, 70', 74, 74'), mittels derer der Sensor (22, 22') relativ zu der Bahn führbar ist.

10. Lagesensorvorrichtung nach einem der vorhergehenden Ansprüche,
**dadurch gekennzeichnet,**
**dass** der Sensor (22, 22') an wenigstens einem flexiblen Element (68, 68', 70, 70') gehalten ist.

11. Lagesensorvorrichtung nach einem der vorhergehenden Ansprüche,
**gekennzeichnet durch**
eine Sicherungseinrichtung (12), mittels derer der Sensor (22, 22') in einer justierten Lage sicherbar ist.

12. Lagesensorvorrichtung nach einem der vorhergehenden Ansprüche,
**dadurch gekennzeichnet,**
**dass** die Sicherungseinrichtung (12) eine Klemmeinrichtung aufweist, mittels derer wenigstens der Abschnitt (90, 90') des flexiblen Schaltungsträgers (24), auf dem der Sensor (22, 22') angeordnet ist, und/oder der Sensor (22, 22') und/oder die Aufnahme (70, 70') in seiner bzw. ihrer Lage relativ zu einem Träger (10) der Vorrichtung festlegbar ist.

13. Lagesensorvorrichtung nach Anspruch 12,
**dadurch gekennzeichnet,**
die Klemmeinrichtung eine an einem Träger (10) schwenkbar gehaltene Klappe (12) umfasst.

14. Lagesensorvorrichtung nach Anspruch 13,
**dadurch gekennzeichnet,**
**dass** die Klappe (12) mittels einer Rast- und/oder Schraubverbindung (26, 50, 52) verriegelbar ist.

15. Lagesensorvorrichtung nach einem der vorhergehenden Ansprüche,
**dadurch gekennzeichnet,**
**dass** der Körper (18) an einem Träger (10) der Lagesensorvorrichtung gelagert ist.

16. Schalter mit
einer Lagesensorvorrichtung nach einem der vorhergehenden Ansprüche, bei der der Körper (18) als Betätigungselement oder Koppelglied ausgebildet ist.

## Claims

1. A position sensor apparatus for the detection of the position of a target (62) movable on a pre-determined track and realized by a body (18) or by a section of a body (18), the apparatus comprising
a flexible circuit carrier (24); and
at least one sensor (22, 22') which is arranged on the circuit carrier (24), operates in a non-contact manner, responds to a movement of the target (62) into and/or out of a pre-determined detection zone (102, 102') of the sensor (22, 22') or to the presence of the target (62) in the pre-determined detection zone (102, 102') and whose position is changeable relative to the pre-determined track while at least partly deforming the circuit carrier (24) for the adjustment.

2. A position sensor apparatus in accordance with claim 1, **characterized in that** at least one further sensor (22, 22'), which operates in a non-contact manner, is arranged on the same flexible circuit carrier (24), responds to a movement of the target (62) into and/or out of a pre-determined detection zone (102, 102") of the further sensor (22, 22') or to the presence of the target (62) in the pre-determined detection zone (102, 102') of the further sensor (22, 22'); and **in that** the target (62) is movable into the detection zones (102, 102') of the sensors (22, 22'), with the position of the sensors (22, 22') relative to one another and/or to the track being able to be adjusted while at least partly deforming a section (88, 88') of the circuit carrier (24) between the sensors (22, 22').

3. A position sensor apparatus in accordance with claim 1 or claim 2, **characterized in that** the sensor is a magnetic sensor.

4. A position sensor apparatus in accordance with claim 1 or claim 2, **characterized in that** the sensor (22, 22') has an optoelectronic receiver element.

5. A position sensor apparatus in accordance with claim 4, **characterized in that** the sensor (22, 22') comprises a light barrier or a light scanner.

6. A position sensor apparatus in accordance with any one of the preceding claims, **characterized in that** the flexible circuit carrier (24) has at least one arched compensation section (88, 88') whose shape is changeable by a movement of the sensor (22, 22') relative to the pre-determined track.

7. A position sensor apparatus in accordance with any one of the preceding claims, **characterized in that** the flexible circuit carrier (24) is made such that the sensor (22, 22') is substantially movable along the pre-determined track of the target (62) detectable by the sensor (22, 22').

8. A position sensor apparatus in accordance with any one of the preceding claims, **characterized in that** the sensor (22, 22') is seated in a mount (70, 70') which is held movably in or at a holder (10) of the apparatus.

9. A position sensor apparatus in accordance with any one of the preceding claims, **characterized by** a guide (40, 70, 70', 74, 74') by means of which the sensor (22, 22') is guidable relative to the track.

10. A position sensor apparatus in accordance with any one of the preceding claims, **characterized in that** the sensor (22, 22') is held at at least one flexible element (68, 68', 70, 70').

11. A position sensor apparatus in accordance with any one of the preceding claims, **characterized by** a securing device (12) by means of which the sensor (22, 22') can be secured in an adjustable position.

12. A position sensor apparatus in accordance with any one of the preceding claims, **characterized in that** the securing device (12) has a clamping device by means of which at least the section (90, 90') of the flexible circuit carrier (24) on which the sensor (22, 22') is arranged and/or the sensor (22, 22') and/or the mount (70, 70') is/are fixable in its/their position relative to a holder (10) of the apparatus.

13. A position sensor apparatus in accordance with claim 12, **characterized in that** the clamping device includes a flap (12) pivotably held at a holder (10).

14. A position sensor apparatus in accordance with claim 13, **characterized in that** the flap (12) is latchable by means of a latch connection and/or a screw connection (26, 50, 52).

15. A position sensor apparatus in accordance with any one of the preceding claims, **characterized in that** the body (19) is supported on a holder (10) of the position sensor apparatus.

16. A switch comprising a position sensor apparatus in accordance with any one of the preceding claims in which the body (18) is made as an actuating element or as a coupling member.

## Revendications

1. Dispositif à capteurs de position pour la détection de la position d'une cible (62) déplaçable sur une trajectoire prédéfinie, définie par un corps (18) ou un segment de corps (18), avec un porte-circuits (24) flexible et au moins un capteur (22, 22') fonctionnant sans contact, disposé sur le porte-circuits (24), lequel capteur réagit à un mouvement de la cible (62) dans une zone de détection (102, 102') prédéfinie du capteur (22, 22') et/ou à l'extérieur de celle-ci ou à la présence de la cible (62) dans la zone de détection (102, 102') prédéfinie et dont la position peut être modifiée pour l'ajustement par rapport à la trajectoire prédéfinie avec déformation au moins partielle du porte-circuits (24).

2. Dispositif à capteurs de position selon la revendication 1, **caractérisé en ce qu'**au moins un capteur (22, 22') complémentaire fonctionnant sans contact est disposé sur le même porte-circuits (24) flexible, lequel réagit à un mouvement de la cible (62) dans une zone de détection (102, 102') prédéfinie du capteur (22, 22') complémentaire et/ou à l'extérieur de celle-ci ou à la présence de la cible (62) dans la zone de détection (102, 102') prédéfinie du capteur (22, 22') complémentaire, et **en ce que** la cible (62) est déplaçable dans les zones de détection (102, 102') des capteurs (22, 22'), la position des capteurs (22, 22') l'un par rapport à l'autre et/ou par rapport à la trajectoire pouvant être ajustée avec déformation au moins partielle d'un segment (88, 88') du porte-circuits (24) entre les capteurs (22, 22').

3. Dispositif à capteurs de position selon la revendication 1 ou 2, **caractérisé en ce que** le capteur est un capteur magnétique.

4. Dispositif à capteurs de position selon la revendication 1 ou 2, **caractérisé en ce que** le capteur (22, 22') comporte un élément de réception opto-électronique.

5. Dispositif à capteurs de position selon la revendication 4, **caractérisé en ce que** le capteur (22, 22') comprend une barrière photo-électrique ou un interrupteur optique.

6. Dispositif à capteurs de position selon l'une des revendications précédentes, **caractérisé en ce que** le porte-circuits (24) flexible comporte au moins un segment de compensation (88, 88') bombé dont la forme peut être modifiée par déplacement du capteur (22, 22') par rapport à la trajectoire prédéfinie.

7. Dispositif à capteurs de position selon l'une des revendications précédentes, **caractérisé en ce que** le porte-circuits (24) flexible est réalisé de manière que le capteur (22, 22') soit déplaçable sensiblement le long de la trajectoire prédéfinie de la cible (62) qui peut être détectée par le capteur (22, 22').

8. Dispositif à capteurs de position selon l'une des revendications précédentes, **caractérisé en ce que** le capteur (22, 22') se trouve dans un logement (70, 70') qui est maintenu déplaçable dans ou sur un support (10) du dispositif.

9. Dispositif à capteurs de position selon l'une des revendications précédentes, **caractérisé par** un guidage (40, 70, 70', 74, 74') au moyen duquel le capteur (22, 22') peut être guidé par rapport à la trajectoire.

10. Dispositif à capteurs de position selon l'une des revendications précédentes, **caractérisé en ce que** le capteur (22, 22') est maintenu sur au moins un élément flexible (68, 68', 70,70').

11. Dispositif à capteurs de position selon l'une des revendications précédentes, **caractérisé par** un dispositif de sûreté (12) au moyen duquel le capteur (22, 22') peut être bloqué dans une position ajustée.

12. Dispositif à capteurs de position selon l'une des revendications précédentes, **caractérisé en ce que** le dispositif de sûreté (12) comporte un dispositif de serrage au moyen duquel au moins le segment (90, 90') du porte-circuits (24) flexible, sur lequel est disposé le capteur (22, 22'), et/ou le capteur (22, 22') et/ou le logement (70, 70') peut être ou peuvent être fixés dans sa ou dans leur position par rapport à un support (10) du dispositif.

13. Dispositif à capteurs de position selon la revendication 12, **caractérisé en ce que** le dispositif de serrage comprend un clapet (12) maintenu pivotant sur un support (10).

14. Dispositif à capteurs de position selon la revendication 13, **caractérisé en ce que** le clapet (12) peut être verrouillé au moyen d'une liaison à encliquetage et/ou à vis (26, 50, 52).

15. Dispositif à capteurs de position selon l'une des revendications précédentes, **caractérisé en ce que** le corps (18) est monté sur un support (10) du dispositif à capteurs de position.

16. Interrupteur avec un dispositif à capteurs de position selon l'une des revendications précédentes, dans lequel le corps (18) est conçu sous la forme d'un élément d'actionnement ou d'un organe de couplage.
